# EUROPÄISCHE PATENTANMELDUNG

(11) **EP 1 113 278 A2**
(43) Veröffentlichungstag der Anmeldung: **04.07.2001**
(21) Anmeldenummer: 00124713.9
(22) Anmeldetag: 13.11.2000
(51) Int. Cl.: G01R 21/133, G01R 22/00

(54) **Elektrizitätszähler mit einem zusätzlichen Rechenmodul**

(30) Priorität: 22.12.1999 DE 19962435
(71) Anmelder: Siemens Metering AG, 6300 Zug (CH)
(72) Erfinder: Widmer, Jakob, 6300 Zug (CH); Kostell, George, 29132-9348 Rock Hill S.C. (US)

(57) **Zusammenfassung**

Um bei einem digitalen Elektrizitätszähler (1) Flexibilität bezüglich Anwenderwünsche zu ermöglichen, ist vorgesehen, dass der Elektrizitätszähler (1) zusätzlich zu seinem die Grundzählfunktionen enthaltenen Basiszähler (2), ein zusätzliches Rechenmodul (23) umfasst, mit dem anwenderspezifische Berechnungen oder Funktionen realisiert werden können. Auf diese Weise ist innerhalb des Elektrizitätszählers (1) ein virtueller Zähler gebildet. Bevorzugt ist das zusätzliche Rechenmodul(23) über ein Zugriffsmodul (20) zugänglich und für den Anwender frei programmierbar, ohne dass die geeichte Funktion des Basiszählers verletzt wird.

## Beschreibung

Aus der DE 196 05 653 ist ein digitaler Elektrizitätszähler bekannt, dem über Sensoren für Strom und Spannung Signale eines Verbrauchers oder einer Last zuführbar sind. Die erfaßten Signale werden mittels einem A/D-Wandler digitalisiert und einer digitalen Verarbeitungseinrichtung zugeführt. Dort werden dann mit Hilfe von unterschiedlichen Modulen, die im wesentlichen als Software-Bausteine ausgebildet sind, verschiedenste Berechnungen, insbesondere die Berechnung von Energie- oder Zählwerten, durchgeführt. Dazu sind verschiedenste Rechenoperationen möglich. Die Ausgabe oder Signalisierung der ermittelten Informationen erfolgt dann über ein Display und/oder eine optische oder eine elektrische Schnittstelle. Die Schnittstelle, das Display und eine Tastatur zur Eingabe von Informationen werden über eine Steuereinrichtung aktiviert.

Für Verrechnungszwecke unterliegt ein derartiger Elektrizitätszähler der Eichpflicht und muss daher beglaubigt werden. Dazu ist üblicherweise das Gehäuse oder ein für den Anwender nicht zugänglicher Bereich, z.B. ein mit einer Klappe verschließbarer Raum, mit einer Plombe sicherbar, so daß ein Eingriff in den Zähler, insbesondere in sein Messwerk, erschwert und kontrollierbar ist.

Seitens der Anwender besteht oftmals das Bedürfnis, Funktionen am Zähler zu erweitern oder zu verändern. Dies ist jedoch in der Regel nicht ohne Eingriff in den Zähler möglich, wodurch die Beglaubigung erlischt. Eine Ausnahme stellen unter Umständen modulare Zähler dar, die ohne Verletzung der Eichplombe um Hardwaremodule ergänzt werden können. Ein Zähler mit Zusatzmodul ist beispielsweise aus der DE 197 12 239 C1 bekannt. Das Zusatzmodul kann dabei ebenfalls mit einer Plombierung versehen werden. In dem Fachbuch "Elektrische Energie elektronisch gemessen", Dr.-Ing.Martin Kahmann, vde-Verlag GmbH, 1994, Seiten 154 bis 158, wird ebenfalls die Modularität bei Zählern beschrieben.

Der Erfindung liegt die Aufgabe zugrunde, einen Elektrizitätszähler zur Verfügung zu stellen, bei dem ohne Beeinflussung seines eichpflichtigen Teils eine einfache anwenderspezifische Funktionserweiterung gegeben ist.

Die Lösung der Aufgabe gelingt erfindungsgemäss mit den Merkmalen des Anspruchs 1. Demnach ist ein zusätzliches Rechenmodul vorgesehen, mit welchem anwenderspezifisch Rechenoperationen auf Basis erfaßter Strom- und Spannungswerte vorgenommen werden können. Damit ist quasi ein zusätzlicher virtueller Zähler innerhalb des Zählers geschaffen. Wesentlich ist dabei, dass die für den Anwender zugänglichen Funktionen, insbesondere eine Rechenfunktion, rückwirkungsfrei für den "Basiszähler", das sogenannte Messwerk oder die Grundfunktionen des Zählers ist.

Auf diese Weise wird dem Bedürfnis der Anwender Rechnung getragen, Zusatzfunktionen oder Erweiterungen ohne eine hard- oder softwaremässige Erweiterung des Elektrizitätszählers vorzunehmen. Das zusätzliche Rechenmodul kann dabei je nach Kundenwunsch bereits kundenspezifisch definiert und im Zähler implementiert sein, so dass die gewünschten Funktionen oder Berechnungen sofort abrutbar sind.

Optional kann auch ein Zugriffsmodul, insbesondere ein Editor oder ein Interpreter, vorgesehen sein, so dass die gewünschten Funktionen oder Berechnungen vom Kunden definiert oder verändert werden können. Der Elektrizitätszähler wird somit für vorgebbare Funktionen oder Berechnungen "frei programmierbar", ohne dass eine Zulassung oder Beglaubigung des eigentlichen Zählers verletzt wird.

Mit Vorteil weist das Eingangsmodul einen Multiplizierer zur Erzeugung von Leistungswerten anhand der erfassten Strom- und Spannungssignale vorgeschaltet. Auf diese Weise ist der Rechenaufwand in der Verarbeitungseinrichtung vermindert, wobei bei Ausführung des Multiplizierers als Hardware-Multiplizierers eine schnellere Datenverarbeitung gegeben ist. Auch seitens des Zugriffsmoduls kann somit auf die abgegebenen Leistungswerte zurückgegriffen werden.

Es ist günstig, wenn die digitale Verarbeitungseinrichtung zumindest einen Rechner umfasst. Alternativ ist auch eine Zwei- oder Mehrrechnerausführung denkbar, wobei dann eine Aufgabenverteilung auf die einzelnen Rechner vorgesehen ist. Speziell kann dabei das Ein/Ausgabemodul und gegebenenfalls das Display und weitere Schnittstellen und die Tastatur von einem gemeinsamen Rechner gesteuert sein. Im Sinne der vorliegenden digitalen Verarbeitung der Daten kommen je nach Aufgabe als Rechner ein Mikroprozessor, ein Controller und/oder ein digitaler Signalprozessor zur Anwendung.

Bevorzugt ist das Zugriffsmodul über eine Tastatur oder über eine Schnittstelle und einem externen Eingabegerät für einen Anwender zugänglich. Als Tastatur kann beispielsweise die zählereigene Tastatur zur Anwendung kommen. Damit ist das Zugriffsmodul auf einfache Weise wie ein programmierbarer Taschenrechner bedienbar. Bei Zugang über eine Schnittstelle ist es denkbar, dass das externe Eingabegerät von einer externen Tastatur oder auch von einem PC, Terminal oder Kleinrechner gebildet ist. Auf diese Weise sind gegebenenfalls auch aufwendige Rechenoperationen oder Funktionen eingebbar.

Die mit dem Zugriffsmodul im zusätzlichen Rechenmodul erzeugten Anweisungen oder Formeln sind mit Vorteil speicherbar. Damit ist ein dauerhafter Rückgriff auf die Eingaben möglich. Der hierfür vorgesehene Speicherplatz kann dabei von einem separaten Speicher zur Verfügung gestellt sein oder Teil eines Speichers der Verarbeitungseinrichtung sein. Eine Speichertrennung ist nicht zwingend notwendig, kann jedoch in Einzelfällen oder bei speziellen Anwendungen, insbesondere im Hinblick auf eine Rückwirkungsfreiheit, zweckmässig sein.

Mit Vorteil sind die Strom- und Spannungssensoren ein- oder dreiphasig ausgeführt, so dass eine Anpassung an beliebige Netzarten möglich ist. Bevorzugt ist der Basiszähler einem Bereich erster Zugangspriorität und das zusätzliche Rechenmodul einem Bereich zweiter Zugangspriorität zugeordnet. Der Bereich erster Zugangspriorität weist dabei Mittel zur Anbringung einer Plombe auf. Somit ist der Elektrizitätszähler in seinen Grundfunktionen entsprechend der Eichpflicht ausführbar.

Der Bereich zweiter Zugangspriorität weist gegebenenfalls Mittel zur Abfrage einer Zugriffsberechtigung auf. Somit kann dieser beeinflussbare Bereich ebenfalls gegen Manipulationen geschützt werden. Die Mittel zur Abfrage können im einfachsten Fall durch eine Sicherung, insbesondere eine Plombe, realisiert sein. Weitere Möglichkeiten sind zum Beispiel eine Schlüsselabfrage oder eine Abfrage per Schlüsselwort über die Tastatur.

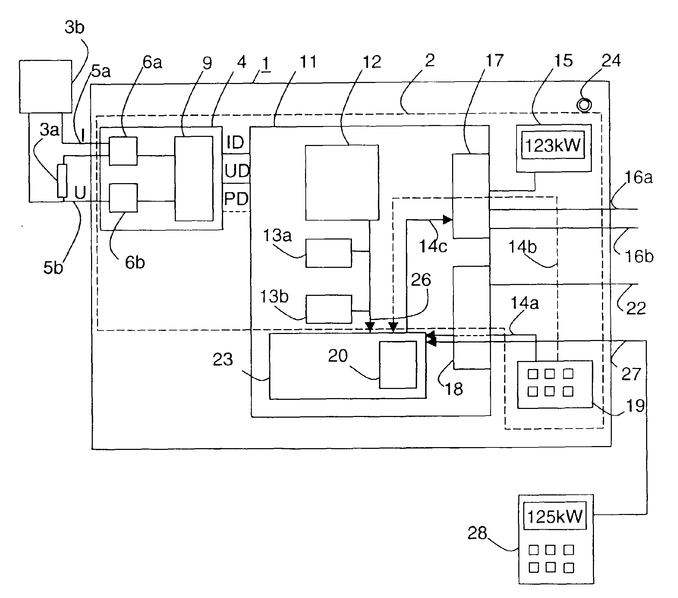

Weitere Vorteile und Details der Erfindung werden nachfolgend anhand eines Ausführungsbeispiels näher erläutert. Die Figur zeigt ein Blockschaltbild für die Hardware eines Elektrizitätszählers. Es sind dabei verschiedenste Funktionen, Bausteine, Hard- und Software gemischt dargestellt, wobei die Übergänge zwischen Hard- und Software gegebenenfalls fliessend sind.

Die einzige Figur zeigt einen Elektrizitätszähler 1 mit einem Basiszähler 2. Der Basiszähler 2 weist prinzipiell alle Funktionen und Mittel auf, um den elektrischen Energieverbrauch eines Verbrauchers oder einer Last 3a zu erfassen, die mit einem elektrischen Netz 3b verbunden ist.

Zum Erfassen der erforderlichen Strom- und Spannungssignale I bzw. U an der Last 3a ist zunächst ein Eingangsmodul 4 vorgesehen, dessen Eingänge 5a, 5b mit einem Strom- bzw. einem Spannungssensor 6a, 6b verbunden sind. Dem Strom- und Spannungssensor 6a, 6b schliesst sich eine Analog/Digital-Wandlereinrichtung 9 an. Somit ist quasi das sogenannte "Front-End" des Basiszählers 3 gebildet. Am Ausgang des Eingangsmoduls 4 stehen symbolisch die digitalisierten Werte UD und ID der zugeführten Strom- und Spannungswerte an. Die Übergabe der Werte kann dabei seriell oder parallel erfolgen. Selbstverständlich kann das Eingangsmodul 4 dreiphasig oder auch mehrfach ausgeführt sein, so dass der Energieverbrauch an Drehstromverbraucher erfasst werden kann. Auch können dem Zähler 1 oder dem Eingangsmodul 4 Wandler zur galvanischen Trennung gemäss dem Stand der Technik vorgeschaltet sein.

Die Sensoren 6a, 6b des Eingangsmoduls 4 können beliebig nach dem Stand der Technik ausgebildet sein. Für die Spannungserfassung kommt insbesondere eine Lösung mit Spannungsteiler oder einem Spannungswandler zum Einsatz. Der Stromsensor 6a kann beispielsweise von einem Hallelement oder einem herkömmlichen Stromwandler mit Spule gebildet sein. Auch ist eine Lösung mit einem Shunt möglich. Gegebenenfalls ist auch eine Verbindung des so gebildeten Strom- und Spannungspfades durch ein gemeinsames Hallelement möglich, wodurch gleichzeitig eine Bildung von Leistungswerten durch die Muliplizierwirkung des Hallelements möglich ist. Beispielhaft ist hierzu am Ausgang des Eingangsmoduls 4 der digitalisierte Leistungswert PD gezeigt.

Selbstverständlich sind auch weitere schaltungstechnische Details, z.B. die Verwendung von Multiplexern zur Bildung der Mehrphasigkeit, innerhalb des Eingangsmoduls 4 möglich. Für die Analog/Digital-Wandlereinrichtung 9 kommt bevorzugt ein Sigma-Delta-Wandler zum Einsatz. Gegebenenfalls können zur Bildung einer mehrkanaligen Wandlereinrichtung auch mehrere Signalwandler zum Einsatz kommen. Zur Bildung eines Leistung- oder Energiewertes innerhalb des Eingangsmoduls 4 kann auch ein zusätzlicher Multiplizierer verwendet werden.

Am Ausgang des Eingangsmoduls 4 stehen somit die digitalisierten Werte ID, UD, von Strom 1 und Spannung U und gegebenenfalls auch ein Leistungs- oder Energiewert PD zur Weitergabe an eine digitale Verarbeitungseinrichtung 11 an. Die digitale Verarbeitungseinrichtung 11 weist als zentrale Komponente einen Rechner 12 auf, der zum Beispiel als Mikroprozessor oder digitaler Signalprozessor ausgebildet sein kann. Er dient im wesentlichen zur Verarbeitung der vom Eingangsmodul 4 gelieferten Signalwerte.

Dem Rechner 12 ist zumindest ein Speicher 13a und gegebenenfalls auch ein weiterer Speicher 13b zugeordnet. Der Speicher 13a ist bevorzugt als ROM ausgebildet und umfasst im wesentlichen das Betriebsprogramm und sonstige Software für den Rechner 12. Der Speicher 13b kann als RAM ausgebildet sein, so dass hier Daten oder Werte vom Rechner 12 zwischengespeichert werden können. Auf Basis abgespeicherter Formeln, Prozeduren oder Routinen ermittelt der Rechner 12 die gewünschten Energiewerte und gibt diese an ein Ein/Ausgabemodul 17 weiter.

Das Ein/Ausgabemodul 17 dient zum Ansteuern eines Displays 15 und weiterer Schnittstellen 16a und 16b, welche beispielsweise als optische bzw. elektrische Schnittstellen ausgebildet sein können. Somit ist über das Ein/Ausgabemodul 17 und die nachgeschalteten Mittel eine Ausgabe der ermittelten Energiewerte und eine Kommunikation mit dem Elektrizitätszähler 1 möglich. Weiterhin kann optional ein Eingabemodul 18 vorgesehen sein, das als Kommunikationsschnittstelle für einzugebende Informationen dient. Über das Eingabemodul 18 kann beispielsweise eine Tastatur 19 (über Linie 14a) und gegebenenfalls eine weitere Schnittstelle 22 zur Eingabe von Informationen angeschlossen sein. Bevorzugt dient das Eingabemodul 18 nur für den Zugriff auf das Zugriffsmodul 20 oder das zusätzliche Rechenmodul 23.

Das Ein/Ausgabemodul 17 und das Eingabemodul 18 können gegebenenfalls einen gemeinsamen Rechner, Mikroprozessor oder Controller aufweisen. Selbstverständlich sind entsprechende übliche Hardwaremittel, z.B. Optokoppler, Koppelelemente, Stromversorgung usw., zur Ausführung der jeweiligen Funktionenen vorzusehen. Im einfachsten Fall kann die Steuerung oder die Ausführung von Ein/Ausgabemodul 17 und Eingabemodul 18 auch vom Rechner 12 erfolgen.

Mit diesen Elementen, Bausteinen, Modulen und Funktionen sind die Grundfunktionen des Basiszählers 2 entsprechend dem Stand der Technik beschrieben. Dieser Basiszähler 2 bildet gegebenenfalls mit seinem nicht näher dargestelltem Gehäuse einen ersten Zugriffsbereich, der der Eichpflicht unterliegt. Symbolisch ist hierzu am Basiszähler 2 eine Öse 24 zur Anbringung einer Plombe dargestellt. Der Basiszähler 2 ist somit versiegelt, so dass ein Eingriff auf seine funktionswesentlichen Teile überprüfbar ist.

Gemäss der vorliegenden neuen Idee weist die Verarbeitungseinrichtung 11 ein zusätzliches Rechenmodul 23 auf. Dieses Zusätzliche Rechenmodul 23 ist im wesentlichen als Programm ausgeführt und kann daher bevorzugt vom Rechner 12 der Verarbeitungseinrichtung 11 ausgeführt werden. Da es sich hier um keine zeitkritische Funktion handelt, ist es auch denkbar, dass diese Funktion von einem anderen Rechner innerhalb der Verarbeitungseinrichtung 11, z.B. vom Rechner des Ein/Ausgabemoduls 17 ausgeführt wird.

Sinn und Zweck des zusätzlichen Rechenmoduls 23 ist es, dass vom Anwender ohne jegliche Beeinflussung der Funktionen des Basiszählers 3 zusätzliche Funktionen oder Berechnungen durchgeführt und ggf. eingegeben oder programmiert werden können, wodurch innerhalb eines Zählers ein "Spezialzähler" mit anwenderspezifischen Funktionen realisiert ist. Dafür ist es zunächst erforderlich, dass dem zusätzlichen Rechenmodul 23 beliebige Daten der Verarbeitungseinrichtung 11 zur Verfügung stehen. Dies ist mit der Wirkverbindungslinie 26 angedeutet. Wesentlich dabei ist, dass eine für die Funktion des Basiszählers 3 erforderliche Rückwirkungsfreiheit beim Zugriff auf die Daten gegeben ist. Sinngemäss ist also zwischen der Basiszählerfunktion und der Rechenmodulfunktion eine sogenannte "Firewall" zwischengeschaltet. In einer Grundausführung kann der Elektrizitätszähler 1 mit einer fest vorgegebenen Anzahl von Zusatzfunktionen ausgerüstet sein, die dem Anwender zur Verfügung stehen.

Das zusätzliche Rechenmodul 23 weist optional ein Zugriffsmodul 20 im Sinne eines Editors oder Interpreters auf, mit welchem die Zusatzfunktionen aktivierbar oder veränderbar sind. Das Zugriffsmodul 20 dient im wesentlichen dazu, Formeln oder Verarbeitungsschritte im zusätzlichen Rechenmodul 23 vorzugeben oder zu aktivieren, die auf Basis der zugänglichen Daten Berechnungen oder Funktionen ausführen. Das zusätzliche Rechenmodul 23 kann dazu entweder einen eigenen nicht näher dargestellten Speicher oder gegebenenfalls einen von den Speichern 13a und 13b zugewiesenen Speicherbereich für einen Programmzugriff und zur Ablage von Informationen umfassen. Im wesentlichen ist dazu erforderlich, dass ein zugeordneter Speicherbereich zur Ablage von eingegebenen Formeln oder Verarbeitungsschritten vorhanden ist. Für die Übergabe von Daten oder Werten kann gegebenenfalls ein neutraler Übergabespeicherbereich vorgesehen sein, durch den die "Firewall" gebildet ist.

Die manuelle Eingabe der Formeln und der Verarbeitungsschritte erfolgt bevorzugt über die Tastatur 19, welche über die Wirklinien 14b oder 14a über das Ein/Ausgabemodul 17 bzw. dem Eingabemodul 18 mit dem zusätzlichen Rechenmodul 23 in Verbindung steht. Das zusätzliche Rechenmodul 23 ist dabei gegenüber dem Basiszähler 2 einem Bereich zweiter Zugriffsberechtigung zugeordnet. Im einfachsten Fall kann somit das Zugriffsmodul 20 frei zugänglich sein. Sollen hier Zugangsbeschränkungen vorgesehen werden, so können Mittel zur Freigabe oder Abfrage der Berechtigung vorgesehen sein. Dazu ist es beispielsweise denkbar, dass die Tastatur 19 über eine Schlüsselfunktion zugänglich ist. Diese Schlüsselfunktion kann beispielsweise durch in Hardwareschlüssel oder eine Schlüsselabfrage in Form eines Schlüsselwortes, das per Tastatur eingegeben wird, realisiert sein.

Selbstverständlich kann auch eine zusätzliche interne oder externe Tastatur vorgesehen sein. Die einfachste Ausführungsform sieht vor, dass im wesentlichen alle Hardware-Elemente des Basiszählers 3, insbesondere die Tastatur 19 und das Display 15, für die Realisierung der Zusatzfunktionen genutzt werden. Das Zugriffsmodul 20 ist alternativ oder zusätzlich auch über eine optionale Schnittstelle 27 mittels einem externen Eingabegerätes 28 zugänglich. Das externe Eingabegerät 28 kann dabei als üblicher PC oder sonstiges Handheldterminal oder Tastatur mit Display ausgebildet sein.

Wichtig für die neue Funktion ist, dass mittels des zusätzlichen Rechenmoduls 23 innerhalb des Elektrizitätszählers 1, insbesondere innerhalb seines Gehäuses, ein zusätzlicher Zähler oder ein sogenannter "virtueller Zähler" gebildet ist, der speziell nach Massgabe des Anwenders definiert werden kann. Dazu ist es beispielsweise möglich, dass mit Hilfe des Zugriffsmoduls 20 spezielle Energiewerte, z.B. "Fünfeinhalb-Stundenwerte", oder Energiewert-Ueberschreitungen ermittelt werden, dass Netzausfall-Überwachungen, Stromgrenzwert- oder Betrugsversuchsüberwachungen, oder auch spezielle Formeln zur Berechnung eines speziellen Energiewertes eingegeben werden können. Auch können redundante Funktionen , z.B. die Berechnung eines Wertes nach einer alternativen Formel, erzeugt werden. Der virtuelle Zähler unterliegt dabei nicht der Eichvorschrift des Basiszählers.

Das Zugriffsmodul 20 kann dabei auch eine Anzahl von festen Grundfunktionen nach Art einer Bibliothek umfassen, die aktiviert oder geladen werden können. Dies kann z.B. Standardformeln oder Grenzwertfunktionen betreffen, wobei auf Basis dieser "Bausteine" die zu erstellenenden Zusatzfunktionen dann erzeugt werden. Gegebenenfalls kann das Laden oder Erzeugen der "virtuellen Zählerfunktion" über die Schnittstellen 22 oder 27 erfolgen, so dass ein externes Zugriffsmodul, z.B. mit dem Eingabegerät 28, zur Anwendung kommt.

Grundvoraussetzung für die neue Funktion ist, dass die Funktion des virtuellen Zählers rückwirkungsfrei auf alle Funktionen des Basiszählers 3 ist. Dies heisst zum Beispiel, dass bei Verwendung derselben Speicher und desselben Rechners innerhalb der Verarbeitungseinrichtung 11 die Berechnungen des Basiszählers 3 Vorrang haben und keinesfalls beeinflusst werden dürfen. Bei Kollisionen von Verarbeitungsschritten hat der Basiszähler 2 immer Vorrang.

Mit dem zusätzlichen virtuellen Zähler ist auch quasi ein Versuchsfeld für den Anwender gegeben, wobei Zusatzfunktionen selbst erzeugt werden können, ohne dass ein spezieller Zähler oder Zusatzgeräte angeschafft werden müssen. Ein Einsatz eines derartigen Zählers ist insbesondere bei Industrieanwendern denkbar, bei denen innerbetrieblich Zusatzfunktionen gewünscht werden. Weiterhin ist ein derartiger Zähler auch als "Versuchs- oder Testzähler" im Probe- oder Testbetrieb einsetzbar. Alternativ ist jedoch auch ein Einsatz im Haushaltbereich denkbar, bei dem ein Kunde auf Basis eigener Vorgaben eine Kontrolle und entsprechende Auswertungen seines Energieverbrauchs registrieren will.

## Patentansprüche

**1.** Elektrizitätszähler (1) mit einem eichpflichtigen Basiszähler (2) umfassend:
- einen Strom- und einem Spannungssensor (6a bzw. 6b) zur Erfassung von Signalen, die den Energieverbrauch an einer elektrischen Last (3a) repräsentieren,
- einer den Sensoren (6a bzw. 6b) nachgeschalteten Analog/Digital-Wandler-Einrichtung (9) und
- einer digitalen Verarbeitungseinrichtung (11) mit zumindest einem zugeordneten Speicher (13a, 13b), einem Display (15) und/oder einem Ein/Ausgabemodul (17), wobei die digitale Verarbeitungseinrichtung (11) mit einem Rechenmodul auf Basis der erfaßten Signale den Energieverbrauch an der Last (3a) ermittelt und über das Display ( 15) und/oder das Ausgabemodul(17) ausgibt,
**dadurch gekennzeichnet, daß**
ein zusätzliches, nicht der Eichpflicht unterliegendes Rechenmodul (23) vorgesehen ist,
- wobei das Rechenmodul (23) einen rückwirkungsfreien Zugriff auf die in der Verarbeitungseinrichtung (11) ermittelten und/oder gespeicherten Signal- und/ oder Energiewerte hat, und
- vom Rechenmodul (23) berechnete Größen über das Display (15) und/ oder das Ein/Ausgabemodul (17) und /oder ein zusätzliches Ausgabemodul (21) ausgebbar sind.

**2.** Elektrizitätszähler nach Anspruch 1,
**dadurch gekennzeichnet,** daß das Eingangsmodul (4) einen Multiplizierer zur Erzeugung von Leistungswerten (PD) anhand der erfaßten Strom- und Spannungssignale (I, U) umfasst.

**3.** Elektrizitätszähler nach Anspruch 1 oder 2,
**dadurch gekennzeichnet,** daß die digitale Verarbeitungseinrichtung (11) zumindest einen Rechner (12) umfaßt.

**4.** Elektrizitätszähler nach einem der vorhergehenden Ansprüche,
**dadurch gekennzeichnet,** daß dem Rechenmodul (23) ein Zugriffsmodul (20) zugeordnet ist, das zur Vorgabe oder Aktivierung von Anweisungen zur Berechnung von zu ermittelnden Größen auf Basis der Signal- oder Energiewerte im Rechenmodul (23) dient.

**5.** Elektrizitätszähler nach Anspruch 4,
**dadurch gekennzeichnet,** daß das Zugriffsmodul (20) über die Tastatur (19) oder über eine Schnittstelle (16a,16b,22) mit einem externen Eingabegerät für einen Anwender zugänglich ist.

**6.** Elektrizitätszähler nach Anspruch 4 oder 5,
**dadurch gekennzeichnet,** daß mit dem Zugriffsmodul (20) erzeugte Anweisungen oder Formeln speicherbar sind.

**7.** Elektrizitätszähler nach einem der Ansprüche 4, 5 oder 6,
**dadurch gekennzeichnet**, daß der Basiszähler (2) einem Bereich erster Zugangspriorität und das Zugriffsmodul (20) einen Bereich zweiter Zugangspriorität zugeordnet sind.

**8.** Elektrizitätszähler nach Anspruch 7,
**dadurch gekennzeichnet,** daß der Basiszähler (2) zur Bildung seiner Zugangspriorität Mittel (24) zur Anbringung einer Plombe aufweist.

**10.** Elektrizitätszähler nach Anspruch 8 oder 7,
**dadurch gekennzeichnet,** daß der Bereich zweiter Zugangspriorität Mittel zur Abfrage einer Zugriffsberechtigung aufweist.

**11.** Elektrizitätszähler nach einem der vorhergehenden Ansprüche,
**dadurch gekennzeichnet,** daß die Strom- und Spannungssensoren (6a bzw.6b) ein- oder dreiphasig ausgebildet sind.

**12.** Elektrizitätszähler nach einem der vorhergehenden Ansprüche,
**dadurch gekennzeichnet,** daß das Ein/Ausgabemodul (17) von einem Controller oder Mikroprozessor gesteuert ist.
